# EUROPEAN PATENT APPLICATION

(11) **EP 4 779 837 A1**
(43) Date of publication of application: **22.07.2026**
(21) Application number: 24865733.0
(22) Date of filing: 29.08.2024
(51) Int. Cl.: H02J 7/00, H02J 7/34, G01R 19/165, G01R 19/30, G08C 19/02, H01M 10/44, H01M 10/48, H01M 10/42

(54) **ENERGY STORAGE SYSTEM AND METHOD FOR PERFORMING VOLTAGE BALANCING BETWEEN SERIALLY CONNECTED ENERGY STORAGE MODULES**

(30) Priority: 13.09.2023 KR 20230122087
(71) Applicant: LS Materials Co., Ltd., Anyang-si, Gyeonggi-do 14118 (KR)
(72) Inventor: KIM, Sung-Hyun, Anyang-si, Gyeonggi-do 14118 (KR); LEE, Jung-Gul, Anyang-si, Gyeonggi-do 14118 (KR)
(74) Representative: Slingsby Partners LLP
(86) International application number: PCT/KR2024/012968
(87) International publication number: WO 2025/058292

(57) **Abstract**

Disclosed is an energy storage system and method that performs voltage balancing between energy storage modules by direct communication between the energy storage modules connected in series without configuring a separate circuit for voltage balancing. The energy storage system includes a plurality of energy storage modules connected in series, each energy storage module including a plurality of unit cells; and a voltage balancing device installed in each energy storage module, the voltage balancing devices in the plurality of energy storage modules being configured to communicate with each other to perform voltage balancing among the plurality of energy storage modules.

## Description

### TECHNICAL FIELD

This application is based on and claims priority from Korean Patent Application No. 10-2023-0122087, filed on September 13, 2023, with the Korean Intellectual Property Office, the disclosure of which is incorporated herein in its entirety by reference.

The present disclosure relates to an energy storage system and method for performing voltage balancing between energy storage modules, and more specifically, to an energy storage system and method for performing voltage balancing between energy storage modules connected in series.

### BACKGROUND ART

Generally, an energy storage module includes multiple unit cells connected in series to achieve high voltages. The energy storage module is generally not used as a single module, and rather a plurality of energy storage modules are typically connected in series to be implemented as a single pack. Appropriate voltage balancing must be performed within the pack or the energy storage modules.

Voltage balancing refers to the process of detecting an energy storage module whose voltage is higher or lower than the reference voltage and discharging or charging the corresponding energy storage module to adjust the corresponding energy storage module to the reference voltage. If voltage balancing is not performed properly, cell deterioration is accelerated, shortening the lifespan, and the stability and reliability of the entire system cannot be guaranteed.

Conventionally, for voltage balancing of an energy storage system including energy storage modules, a voltage balancing device is installed in each energy storage module, and each voltage balancing device is controlled by a controller to adjust the voltage deviation between the energy storage modules using passive balancing or active balancing technology. In order to control each voltage balancing device with a controller, a separate circuit is required for connection between each voltage balancing device and the controller that controls the voltage balancing device. Since a separate circuit is configured for voltage balancing in this way, there are problems in that the size of the printed circuit board increases, the circuit becomes more complex, and the number of defect occurrence points increases.

### DISCLOSURE

### Technical Problem

The present disclosure is designed to solve the problems of the related art, and therefore the present disclosure is directed to providing an energy storage system and method that performs voltage balancing between energy storage modules by direct communication between the energy storage modules connected in series without configuring a separate circuit for voltage balancing.

### Technical Solution

In one aspect of the present disclosure, there is provided an energy storage system comprising: a plurality of energy storage modules connected in series, each energy storage module including a plurality of unit cells; and a voltage balancing device installed in each energy storage module, the voltage balancing devices in the plurality of energy storage modules being configured to communicate with each other to perform voltage balancing among the plurality of energy storage modules.

The voltage balancing device may include a voltage measurement unit configured to measure a voltage value of an energy storage module in which the voltage balancing device is installed; a communication unit configured to communicate with other voltage balancing devices installed in other energy storage modules and receive voltage values of the other energy storage modules; and a processing unit configured to perform voltage balancing of the energy storage module in which the voltage balancing device is installed based on the measured voltage value and the received voltage values of the other energy storage modules.

The communication unit may be configured to transmit and receive voltage values to/from the other voltage balancing devices through a CAN (Controller Area Network) communication message, and in an ID field of the CAN communication message, the serially connected energy storage modules may have the same node ID, and each energy storage module has a different module ID.

The processing unit may perform voltage balancing of the energy storage module in which the voltage balancing device is installed, when the measured voltage value is greater than an average voltage value of the other energy storage modules by a predetermined value or more.

The processing unit may perform voltage balancing of the energy storage module in which the voltage balancing device is installed, when a difference between a largest voltage value and a smallest voltage value among the voltage values of the other energy storage modules is greater than a predetermined threshold value and the measured voltage value is greater than an average of the largest voltage value and the smallest voltage value.

The processing unit may perform voltage balancing of the energy storage module in which the voltage balancing device is installed, when the measured voltage value is higher than or equal to an alarm reference value.

The processing unit may perform voltage balancing between unit cells within the energy storage module, after voltage balancing of the energy storage module in which the voltage balancing device is installed is completed.

The voltage measurement unit may measure voltage values of the unit cells, and the processing unit may perform voltage balancing of a specific unit cell, when the voltage value of the specific unit cell is greater than an average voltage value of the other unit cells by a predetermined value or more.

The voltage measurement unit may measure voltage values of the unit cells, and the processing unit may perform voltage balancing of a specific unit cell, when a difference between a largest voltage value and a smallest voltage value among the voltage values of the unit cells other than the specific unit cell is greater than a predetermined threshold value and the voltage value of the specific unit cell is greater than an average of the largest voltage value and the smallest voltage value.

The processing unit may perform voltage balancing of a specific unit cell, when the voltage value of the specific unit cell is greater than or equal to an alarm reference value.

In another aspect of the present disclosure, there is also provided a voltage balancing method of each voltage balancing device installed in each energy storage module in an energy storage system that includes a plurality of energy storage modules connected in series, each energy storage module including a plurality of unit cells, the voltage balancing method comprising: performing voltage balancing among the plurality of energy storage modules by communicating with voltage balancing devices installed in other energy storage modules.

The step of performing may include measuring a voltage value of an energy storage module in which the voltage balancing device is installed; communicating with the other voltage balancing devices installed in the other energy storage modules to receive voltage values of the other energy storage modules; and performing voltage balancing of the energy storage module in which the voltage balancing device is installed based on the measured voltage value and the received voltage values of the other energy storage modules.

The step of receiving may include receiving voltage values from the other voltage balancing devices through a CAN (Controller Area Network) communication message, and in an ID field of the CAN communication message, the serially connected energy storage modules may have the same node ID, and each energy storage module has a different module ID.

The step of performing voltage balancing of the energy storage module in which the voltage balancing device is installed may include performing voltage balancing of the energy storage module in which the voltage balancing device is installed, when the measured voltage value is greater than an average voltage value of the other energy storage modules by a predetermined value or more.

The step of performing voltage balancing of the energy storage module in which the voltage balancing device is installed may include performing voltage balancing of the energy storage module in which the voltage balancing device is installed, when a difference between a largest voltage value and a smallest voltage value among the voltage values of the other energy storage modules is greater than a predetermined threshold value and the measured voltage value is greater than an average of the largest voltage value and the smallest voltage value.

The voltage balancing method may further comprise performing voltage balancing of the energy storage module in which the voltage balancing device is installed, when the measured voltage value is higher than or equal to an alarm reference value.

The voltage balancing method may further comprise performing voltage balancing between unit cells within the energy storage module, after voltage balancing of the energy storage module in which the voltage balancing device is installed is completed.

The step of performing voltage balancing between unit cells may include measuring voltage values of the unit cells, and performing voltage balancing of a specific unit cell, when the voltage value of the specific unit cell is greater than an average voltage value of the other unit cells by a predetermined value or more.

The step of performing voltage balancing between unit cells may include measuring voltage values of the unit cells, and performing voltage balancing of a specific unit cell, when a difference between a largest voltage value and a smallest voltage value among the voltage values of the unit cells other than the specific unit cell is greater than a predetermined threshold value and the voltage value of the specific unit cell is greater than an average of the largest voltage value and the smallest voltage value.

The step of performing voltage balancing between unit cells may include measuring voltage values of the unit cells, and performing voltage balancing of a specific unit cell, when the voltage value of the specific unit cell is greater than or equal to an alarm reference value.

### Advantageous Effects

According to the present disclosure, voltage balancing between energy storage modules may be achieved through direct communication between the energy storage modules connected in series without configuring a separate circuit for voltage balancing.

### DESCRIPTION OF DRAWINGS

FIG. 1 is a diagram showing the configuration of an energy storage system according to an embodiment of the present disclosure.
FIG. 2 is an example showing a 29-bit ID field of an extended CAN according to an embodiment of the present disclosure.
FIG. 3 is a diagram showing the configuration of a voltage balancing device according to an embodiment of the present disclosure.
FIG. 4 is a flowchart for illustrating a voltage balancing method between energy storage modules according to an embodiment of the present disclosure.
FIG. 5 is a flowchart for illustrating a voltage balancing method between cells within an energy storage module according to an embodiment of the present disclosure.
FIG. 6 is a diagram showing an experimental example of voltage balancing according to an embodiment of the present disclosure.

### BEST MODE

Hereinafter, embodiments of the present specification will be described in detail with reference to the attached drawings. Here, identical or similar components will be assigned the same reference numbers, and duplicate descriptions thereof will be omitted. The term "... unit" used in component names in the following description is given or used only considering the ease of preparing the specification, and does not have a distinct meaning or role in itself. Also, in describing the embodiments disclosed in this specification, if it is deemed that detailed descriptions of related known technologies may obscure the gist of the embodiments disclosed in this specification, the detailed descriptions will be omitted. In addition, the attached drawings are only intended to facilitate understanding of the embodiments disclosed in this specification, and the technical idea disclosed in this specification is not limited by the attached drawings, and it should be understood that all of modifications, equivalents or substitutes are included in the idea and scope of the present disclosure.

Terms that include ordinal numbers, such as "first", "second", etc., may be used to describe various components, but the components are not limited by the terms. The terms are used only to distinguish one component from another.

Singular expressions include plural expressions unless the context clearly dictates otherwise. In this application, terms such as "include" or "have" are intended to designate the presence of features, numbers, steps, operations, components, parts, or combinations thereof described in the specification, and it should be understood that these terms do not exclude in advance the possibility of the presence or addition of one or more other features, elements, numbers, steps, operations, components, parts, or combinations thereof.

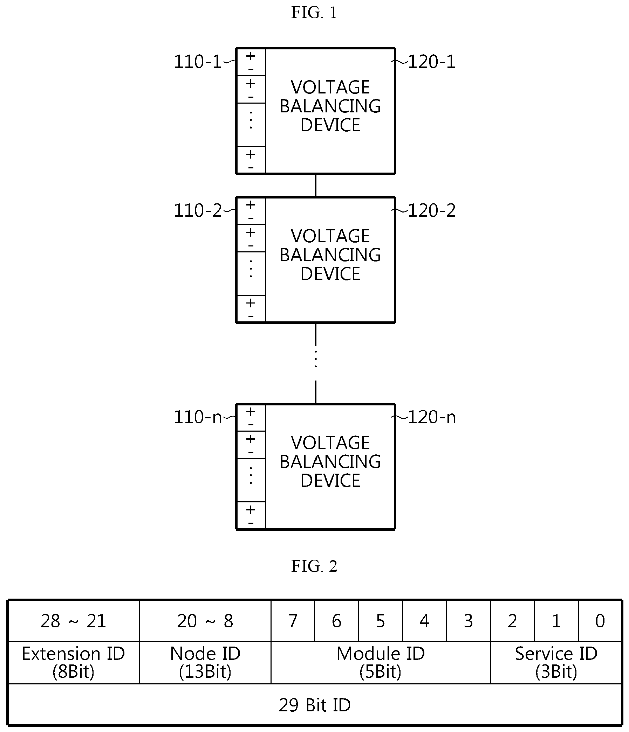

FIG. 1 is a diagram showing the configuration of an energy storage system according to an embodiment of the present disclosure. Referring to FIG. 1, the energy storage system according to the present embodiment includes a plurality of energy storage modules 110-1, 110-2, ..., 110-n connected in series, and each energy storage module 110-1, 110-2, ..., 110-n includes a plurality of unit cells and voltage balancing devices 120-1, 120-2, ..., 120-n connected in series. In this embodiment, only the plurality of energy storage modules 110-1, 110-2, ..., 110-n connected in series are illustrated and described, but the present invention is not limited thereto, and multiple sets of the plurality of energy storage modules 110-1, 110-2, ..., 110-n connected in series may be provided and connected to each other in parallel to implement the energy storage system.

A unit cell refers to an energy storage device such as a rechargeable secondary battery, an electrolytic capacitor, or an ultra-capacitor having characteristics intermediate between an electrolytic capacitor and a secondary battery. Within each energy storage module 110-1, 110-2, ..., 110-n, positive and negative electrodes of adjacent unit cells are electrically connected in series via a bus bar or the like. The number of unit cells within each energy storage module 110-1, 110-2, ..., 110-n and the number of energy storage modules 110-1, 110-2, ..., 110-n may be determined according to the operating voltage required in an application to be applied.

The voltage balancing devices 120-1, 120-2, ..., 120-n installed in each energy storage module 110-1, 110-2, ..., 110-n are connected to each other to perform communication and are also connected to all unit cells installed in the corresponding energy storage module 110-1, 110-2, ..., 110-n to perform voltage balancing between the energy storage modules 110-1, 110-2, ..., 110-n and voltage balancing between the cells in the energy storage module 110-1, 110-2, ..., 110-n. Preferably, the voltage balancing devices 120-1, 120-2, ..., 120-n perform CAN (Controller Area Network) communication. Here, the balancing is generally passive balancing.

Conventionally, in order to perform voltage balancing of an energy storage system composed of energy storage modules, a voltage balancing device is installed in each energy storage module, and each voltage balancing device is controlled by a controller, so a separate circuit is required for connection between each voltage balancing device and the controller that controls the voltage balancing device. However, in the present disclosure, since the voltage balancing devices 120-1, 120-2, ..., 120-n perform voltage balancing by performing CAN communication, a controller for controlling the voltage balancing device 120-1, 120-2, ..., 120-n is not required, and therefore, a separate circuit for connecting the voltage balancing device 120-1, 120-2, ..., 120-n and the controller is not required.

In addition, conventionally, voltage balancing is performed by connecting a resistor to the positive electrode and/or the negative electrode of the energy storage module for voltage balancing between energy storage modules, but in the present disclosure, voltage balancing between modules and voltage balancing between cells is performed by on/off control of a balancing channel of each cell in the energy storage module 110-1, 110-2, ..., 110-n without using a separate external resistor.

CAN communication is a message-based protocol, and data is transmitted and received in the form of frames. Each frame is identified by an ID field, and the ID field is 11 bits long in standard CAN and 29 bits long in extended CAN. In the present disclosure, the ID field in CAN communication is used to determine the priority of a message and whether or not to receive a message. This embodiment uses the 29-bit extended CAN as an example. FIG. 2 is an example showing a 29-bit ID field of an extended CAN according to an embodiment of the present disclosure. Referring to FIG. 2, the ID field includes a 3-bit service ID field, a 5-bit module ID field, a 13-bit node ID field, and an 8-bit extension ID field. In this embodiment, the serially connected energy storage modules 110-1, 110-2, ..., 110-n are set to use the same node ID. That is, the voltage balancing devices 120-1, 120-2, ..., 120-n of the serially connected energy storage modules 110-1, 110-2, ..., 110-n communicate using the same node ID and identify the voltage balancing devices 120-1, 120-2, ..., 120-n of other energy storage modules 110-1, 110-2, ..., 110-n based on the module ID. Meanwhile, if the energy storage modules 110-1, 110-2, ..., 110-n are connected in parallel, the energy storage modules 110-1, 110-2, ..., 110-n are set to use different node IDs.

The voltage balancing devices 120-1, 120-2, ..., 120-n installed in each energy storage module 110-1, 110-2, ..., 110-n are connected to each other to communicate and perform voltage balancing between the energy storage modules 110-1, 110-2, ..., 110-n and voltage balancing between the cells within the energy storage module 110-1, 110-2, ..., 110-n. Since the voltage balancing operation of each voltage balancing device 120-1, 120-2, ..., 120-n is performed independently and identically, the following description will be based on the voltage balancing device 120-1 of the first energy storage module 110-1.

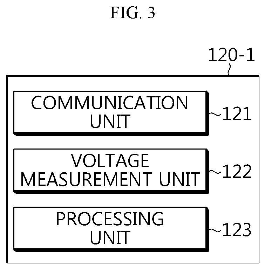

FIG. 3 is a diagram showing the configuration of a voltage balancing device 120-1 according to an embodiment of the present disclosure. Referring to FIG. 3, the voltage balancing device 120-1 includes a communication unit 121, a voltage measurement unit 122, and a processing unit 123. The processing unit 123 may be a microprocessor, but is not limited thereto, and may include a processing circuit such as a DSP, an ASIC, an FPGA, and may operate according to a program stored in a memory. Hereinafter, voltage balancing between the energy storage modules 110-1, 110-2, ..., 110-n is first described, and then voltage balancing between cells within one energy storage module 110-1 is described.

First, the voltage measurement unit 122 of the voltage balancing device 120-1 measures the voltage value of the energy storage module 110-1 in which the voltage measurement unit 122 is installed. Also, the processing unit 123 checks whether the voltage value of the energy storage module 110-1 measured by the voltage measurement unit 122 is equal to or higher than the alarm reference value. If the voltage value of the energy storage module 110-1 is equal to or higher than the alarm reference value, the processing unit 123 performs module voltage balancing by performing passive balancing in a lump on all unit cells installed in the energy storage module 110-1. That is, the processing unit 123 turns on the balancing channels of all unit cells in the energy storage module 110-1 so that the voltage value of the energy storage module 110-1 is lowered to the reference voltage value. For example, if the alarm reference value is 15V and the voltage value of the energy storage module 110-1 is 16V, voltage balancing is performed so that the voltage value of the energy storage module 110-1 is lowered to the reference voltage value.

If the voltage value of the energy storage module 110-1 is lower than the alarm reference value, the processing unit 123 receives the voltage value of each of the other energy storage modules 110-2, ..., 110-n through the communication unit 121. The communication unit 121 may identify the other serially connected energy storage modules 110-2, ..., 110-n based on the node ID and the module ID of the message received through CAN communication.

The processing unit 123 averages the voltage values of the other energy storage modules 110-2, ..., 110-n and checks whether the voltage value of the energy storage module 110-1 in which it is installed is greater than the voltage average value by a predetermined value or more. For example, if the voltage average value is 10V, the voltage value of the energy storage module 110-1 is 13V, and the predetermined value is 2V, the voltage value of 13V of the energy storage module 110-1 is greater than 12V, which is a voltage value obtained by adding the predetermined value 2V to the voltage average value 10V.

The processing unit 123 performs module voltage balancing by performing passive balancing on all unit cells installed in the energy storage module 110-1 when the voltage value of the energy storage module 110-1 is greater than the voltage average value by a predetermined value or more. That is, the processing unit 123 performs voltage balancing by turning on the balancing channels of all unit cells in the energy storage module 110-1 so that the voltage value of the energy storage module 110-1 is lowered to a reference voltage value. Alternatively, the processing unit 123 may perform voltage balancing so that the voltage value of the energy storage module 110-1 returns to the voltage average value of other energy storage modules 110-2, ..., 110-n connected in series.

If the voltage value of the energy storage module 110-1 is not greater than the voltage average value by a predetermined value or more, the processing unit 123 checks whether the difference between the largest voltage value and the smallest voltage value among the voltage values of other energy storage modules 110-2, ..., 110-n is greater than a predetermined threshold value, and if the difference between the largest voltage value and the smallest voltage value is greater than the predetermined threshold value, the processing unit 123 checks whether the voltage value of the energy storage module 110-1 is greater than the average of the largest voltage value and the smallest voltage value. For reference, the process of checking whether the difference between the largest voltage value and the smallest voltage value is greater than the predetermined threshold value is to adjust the voltage values of the energy storage modules 110-1, 110-2, ..., 110-n to a low voltage state when there is an energy storage module in a low voltage state among the energy storage modules 110-1, 110-2, ..., 110-n connected in series.

The processing unit 123 performs module voltage balancing by performing passive balancing on all unit cells installed in the energy storage module 110-1 when the voltage value of the energy storage module 110-1 is greater than the average of the largest voltage value and the smallest voltage value. That is, the processing unit 123 may perform voltage balancing for a predetermined period of time by turning on the balancing channels of all unit cells in the energy storage module 110-1 so that the voltage value of the energy storage module 110-1 is lowered to the reference voltage value, or so that the voltage value of the energy storage module 110-1 returns to the voltage average value of other energy storage modules 110-2, ..., 110-n connected in series. After performing voltage balancing, the processing unit 123 returns to the beginning of the operation described above and repeats the operation.

If the difference between the largest voltage value and the smallest voltage value is less than or equal to the predetermined threshold value, or if the voltage value of the energy storage module 110-1 is not greater than the average of the largest voltage value and the smallest voltage value, the processing unit 123 does not perform voltage balancing for the energy storage module 110-1, waits for a predetermined amount of time, and then returns to the beginning of the operation described above and repeats the operation.

The processing unit 123 performs voltage balancing for the predetermined time or waits for the predetermined time when not performing voltage balancing because it is needed to wait until, when other energy storage modules 110-2, ..., 110-n perform voltage balancing operation like energy storage module 110-1, the other energy storage modules 110-2, ..., 110-n complete the operation.

Next, voltage balancing between cells within one energy storage module 110-1 is described. Even if voltage balancing is performed between the energy storage modules 110-1, 110-2, ..., 110-n, voltage deviation may occur between cells within each energy storage module 110-1, 110-2, ..., 110-n, so voltage balancing between the cells is performed. It should be noted that the main feature of the present disclosure is that voltage balancing is performed first between the energy storage modules 110-1, 110-2, ..., 110-n, and then voltage balancing is performed between cells within the energy storage module 110-1, 110-2, ..., 110-n. In the present disclosure, voltage balancing is performed first among the energy storage modules 110-1, 110-2, ..., 110-n to ensure efficient voltage balancing not only in applications that maintain a constant voltage for a long period of time but also in applications with frequent charging and discharging. The operations described below are performed independently for each unit cell.

The voltage measurement unit 122 of the energy storage module 110-1 measures the voltage of each specific unit cell within the energy storage module 110-1. The processing unit 123 checks whether the measured voltage value of the corresponding unit cell is equal to or greater than an alarm reference value, and if so, the processing unit 123 performs voltage balancing for the corresponding specific unit cell so that the voltage value is lowered to the reference voltage value.

If the voltage value of the corresponding specific unit cell is less than the alarm reference value, the processing unit 123 averages the voltage values of other unit cells and checks whether the voltage value of the corresponding specific unit cell is greater than the voltage average value by a predetermined value or more. Here, the predetermined value is, for example, 0.1 V.

The processing unit 123 performs voltage balancing so that the voltage value of the corresponding specific unit cell is lowered to the reference voltage value, if the voltage value of the corresponding specific unit cell is greater than the voltage average value by a predetermined value or more. Alternatively, the processing unit 123 may perform voltage balancing so that the voltage value of the corresponding specific unit cell returns to the voltage average value of other unit cells.

If the voltage value of the corresponding specific unit cell is not greater than the voltage average value by a predetermined value or more, the processing unit 123 checks whether the difference between the largest voltage value and the smallest voltage value among the voltage values of other unit cells is greater than a predetermined threshold value, and if the difference between the largest voltage value and the smallest voltage value is greater than the predetermined threshold value, the processing unit 123 checks whether the voltage value of the corresponding specific unit cell is greater than the average of the largest voltage value and the smallest voltage value. For reference, the process of checking whether the difference between the largest voltage value and the smallest voltage value is greater than the predetermined threshold value is to adjust the voltage value of the unit cells to a low voltage state when there is a unit cell in a low voltage state among the unit cells connected in series.

If the voltage value of the corresponding specific unit cell is greater than the average of the largest voltage value and the smallest voltage value, the processing unit 123 may perform voltage balancing for a predetermined period of time so that the voltage value of the corresponding specific unit cell is lowered to the reference voltage value, or the voltage value of the corresponding specific unit cell returns to the voltage average value of other unit cells connected in series. After performing voltage balancing, the processing unit 123 repeats the operation described above for other unit cells.

If the difference between the largest voltage value and the smallest voltage value is less than or equal to the predetermined threshold value, or if the voltage value of the corresponding specific unit cell is not greater than the average of the largest voltage value and the smallest voltage value, the processing unit 123 does not perform voltage balancing for the corresponding specific unit cell, but waits for a predetermined period of time and then repeats the operation described above for other unit cells.

The processing unit 123 performs voltage balancing for a predetermined period of time or waits for a predetermined period of time when not performing voltage balancing because it is needed to wait until, when other energy storage modules 110-2, ..., 110-n perform voltage balancing operation like the energy storage module 110-1, the other energy storage modules 110-2, ..., 110-n complete the operation.

If voltage balancing for all unit cells is completed, the processing unit 123 restarts voltage balancing operation between the energy storage modules 110-1, 110-2, ..., 110-n.

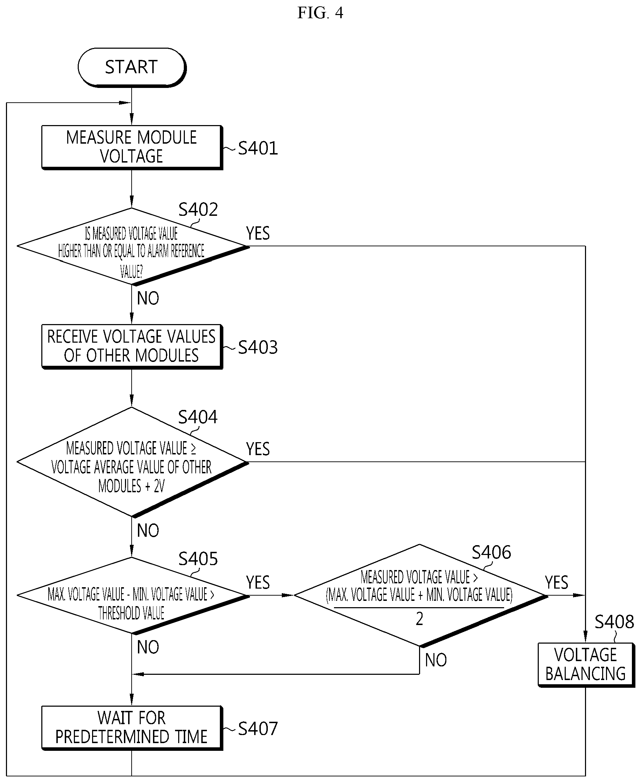

FIG. 4 is a flowchart for illustrating a voltage balancing method between energy storage modules according to an embodiment of the present disclosure, and describes the operation of the voltage balancing device 120-1 of the energy storage module 110-1 among a plurality of energy storage modules 110-1, 110-2, ..., 110-n connected in series as an example. The operation described with reference to FIG. 4 is also performed in the same manner in the voltage balancing devices 120-2, ..., 120-n of other energy storage modules 110-2, ..., 110-n.

Referring to FIG. 4, in step S401, the voltage balancing device 120-1 measures the voltage value of the energy storage module 110-1 in which the voltage balancing device 120-1 is installed. Also, in step S402, the voltage balancing device 120-1 checks whether the measured voltage value of the energy storage module 110-1 is equal to or higher than the alarm reference value.

If the voltage value of the energy storage module 110-1 is higher than or equal to the alarm reference value, in step S408, the voltage balancing device 120-1 turns on the balancing channels of all unit cells in the energy storage module 110-1 to perform voltage balancing so that the voltage value of the energy storage module 110-1 is lowered to the reference voltage value. For example, if the alarm reference value is 15 V and the voltage value of the energy storage module 110-1 is 16 V, voltage balancing is performed so that the voltage value of the energy storage module 110-1 is lowered to the reference voltage value.

Meanwhile, if the voltage value of the energy storage module 110-1 is less than the alarm reference value, in step S403, the voltage balancing device 120-1 receives the voltage values of each of other energy storage modules 110-2, ..., 110-n through the communication unit 121. The voltage balancing device 120-1 may identify other energy storage modules 110-2, ..., 110-n connected in series based on the node ID and the module ID of the message received through CAN communication.

In step S404, the voltage balancing device 120-1 averages the voltage values of the other energy storage modules 110-2, ..., 110-n, and checks whether the voltage value of the energy storage module 110-1 in which the voltage balancing device 120-1 is installed is greater than the voltage average value by a predetermined value or more, for example 2V or more.

If the voltage value of the energy storage module 110-1 is greater than or equal to the voltage average value by a predetermined value or more, in step S408, the voltage balancing device 120-1 performs voltage balancing by turning on the balancing channels of all unit cells in the energy storage module 110-1 so that the voltage value of the energy storage module 110-1 is lowered to a reference voltage value. Alternatively, the voltage balancing device 120-1 may perform voltage balancing so that the voltage value of the energy storage module 110-1 returns to the voltage average value of other energy storage modules 110-2, ..., 110-n connected in series.

Meanwhile, if the voltage value of the energy storage module 110-1 is not greater than the voltage average value by a predetermined value or more, in step S405, the voltage balancing device 120-1 checks whether the difference between the largest (Max.) voltage value and the smallest (Min.) voltage value among the voltage values of the other energy storage modules 110-2, ..., 110-n is greater than a predetermined threshold value.

If the difference between the largest (Max.) voltage value and the smallest (Min.) voltage value is greater than the predetermined threshold value, in step S406, the voltage balancing device 120-1 checks whether the voltage value of the energy storage module 110-1 is greater than the average of the largest (Max.) voltage value and the smallest (Min.) voltage value.

If the voltage value of the energy storage module 110-1 is greater than the average of the largest (Max.) voltage value and the smallest (Min.) voltage value, in step S408, the voltage balancing device 120-1 performs voltage balancing for a predetermined time by turning on the balancing channels of all unit cells in the energy storage module 110-1 so that the voltage value of the energy storage module 110-1 is lowered to the reference voltage value, or the voltage value of the energy storage module 110-1 returns to the voltage average value of other energy storage modules 110-2, ..., 110-n connected in series.

Meanwhile, if the difference between the largest (Max.) voltage value and the smallest (Min.) voltage value is not greater than a predetermined threshold value as a result of checking in step S405, or if the voltage value of the energy storage module 110-1 is not greater than the average of the largest (Max.) voltage value and the smallest (Min.) voltage value as a result of checking in step S406, then in step S407, the voltage balancing device 120-1 does not perform voltage balancing, waits for a predetermined time, and then returns to the beginning of the operation described above and repeats the operation.

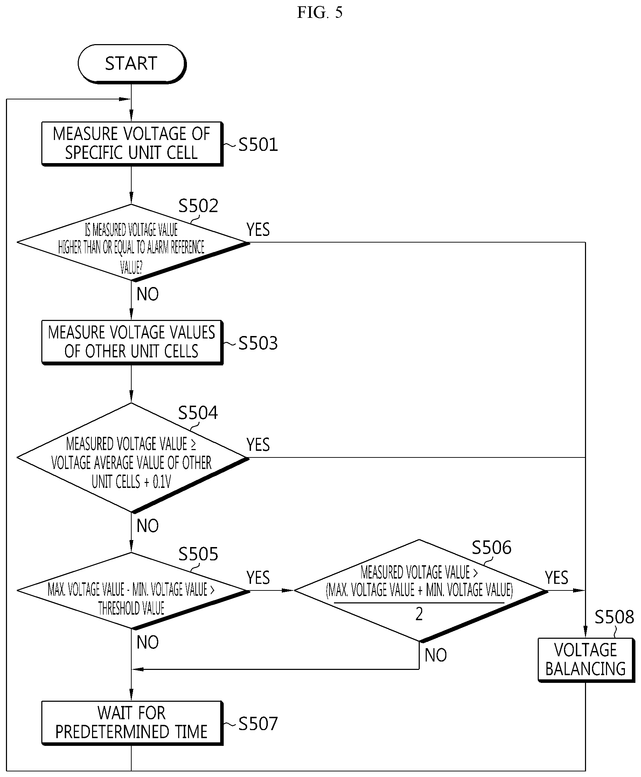

FIG. 5 is a flowchart for illustrating a voltage balancing method between cells within an energy storage module according to an embodiment of the present disclosure, and describes the operation of the voltage balancing device 120-1 of the energy storage module 110-1 among a plurality of energy storage modules 110-1, 110-2, ..., 110-n connected in series as an example. The operation described with reference to FIG. 5 is also performed in the same manner in the voltage balancing devices 120-2, ..., 120-n of other energy storage modules 110-2, ..., 110-n. For reference, the operation described with reference to FIG. 5 may be performed after step S407 or step S408 of the operation described with reference to FIG. 4.

Referring to FIG. 5, in step S501, the voltage balancing device 120-1 measures the voltage value of a specific unit cell in the energy storage module 110-1. Also, in step S502, the voltage balancing device 120-1 checks whether the measured voltage value of the specific unit cell is equal to or higher than an alarm reference value.

If the voltage value of the corresponding specific unit cell is higher than or equal to the alarm reference value, in step S508, the voltage balancing device 120-1 performs voltage balancing so that the voltage value of the corresponding specific unit cells is lowered to the reference voltage value.

Meanwhile, if the measured voltage value of the corresponding specific unit cell is less than the alarm reference value, in step S503, the voltage balancing device 120-1 measures the voltage values of other unit cells.

In step S504, the voltage balancing device 120-1 averages the voltage values of other unit cells and checks whether the voltage value of the corresponding specific unit cell is greater than the voltage average value by a predetermined value or more, for example, by 0.1V or more.

If the measured voltage value of the corresponding specific unit cell is greater than the voltage average value by a predetermined value or more, in step S508, the voltage balancing device 120-1 may perform voltage balancing so that the voltage value of the corresponding specific unit cell is lowered to a reference voltage value, or may perform voltage balancing so that the voltage value of the corresponding specific unit cell returns to the voltage average value of other unit cells connected in series.

Meanwhile, if the voltage value of the corresponding specific unit cell is not greater than the voltage average value by a predetermined value or more, in step S505, the voltage balancing device 120-1 checks whether the difference between the largest (Max.) voltage value and the smallest (Min.) voltage value among the voltage values of the other unit cells is greater than a predetermined threshold value.

If the difference between the largest (Max.) voltage value and the smallest (Min.) voltage value is greater than the predetermined threshold value, in step S506, the voltage balancing device 120-1 checks whether the voltage value of the corresponding specific unit cell is greater than the average of the largest (Max.) voltage value and the smallest (Minx) voltage value.

If the voltage value of the corresponding specific unit cell is greater than the average of the largest (Max.) voltage value and the smallest (Min.) voltage value, in step S508, the voltage balancing device 120-1 performs voltage balancing for a predetermined time so that the voltage value of the corresponding specific unit cell is lowered to the reference voltage value, or the voltage value of the corresponding specific unit cell returns to the voltage average value of other unit cells connected in series.

Meanwhile, if the difference between the largest (Max.) voltage value and the smallest (Min.) voltage value is not greater than the predetermined threshold value as a result of checking in step S505, or if the voltage value of the corresponding specific unit cell is not greater than the average of the largest (Max.) voltage value and the smallest (Min.) voltage value as a result of checking in step S506, then in step S507, the voltage balancing device 120-1 does not perform voltage balancing, waits for a predetermined time, and then returns to the beginning of the operation described above and repeats the operation for other unit cells.

After performing the operation described with reference to FIG. 5 for all unit cells, the voltage balancing device 120-1 performs the voltage balancing operation between energy storage modules described with reference to FIG. 4 again.

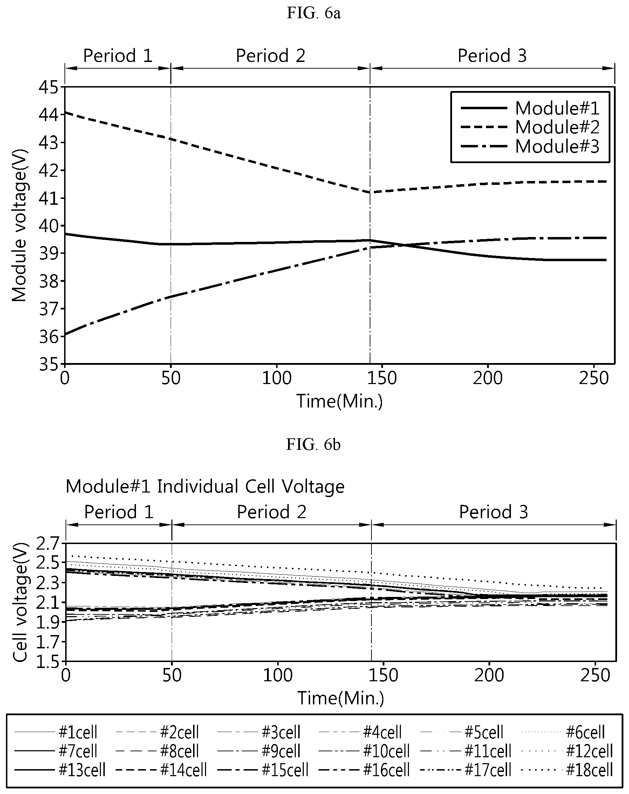

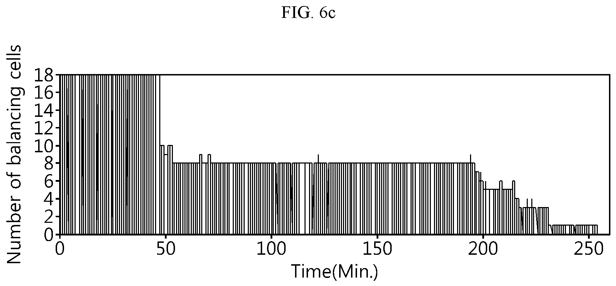

FIG. 6 is a diagram showing an experimental example of voltage balancing according to an embodiment of the present disclosure, and shows the time-dependent process of voltage balancing between three energy storage modules, each including 18 unit cells connected in series.

FIG. 6(a) shows voltages of three energy storage modules (Modules #1, #2, #3) over time, FIG. 6(b) shows voltages of internal unit cells of the energy storage module #1 over time, and FIG. 6(c) shows the number of unit cells performing voltage balancing of the energy storage module #1. In FIGS. 6(a) and 6(b), the X-axis represents time (min) and the Y-axis represents voltage. Also, in FIG. 6(c), the X-axis represents time (min) and the Y-axis represents the total number of cells in which balancing is in progress (i.e., channel ON).

In this embodiment, initially, the voltage of the energy storage module #3 among the three energy storage modules is in a low state. In Period 1, the energy storage modules #1 and #2 lower their voltages according to the voltage balancing method between energy storage modules described above, respectively, and thus the voltage of the energy storage module #3 increases. In Period 1, the energy storage module #1 completes voltage balancing between the energy storage modules, and performs voltage balancing between internal cells in Periods 2 and 3. However, the energy storage module #2 still performs voltage balancing between the energy storage modules in Period 2, and performs voltage balancing between the cells in Period 3. Therefore, the voltage of the energy storage module #3, which does not perform voltage balancing between modules or voltage balancing between cells in Periods 2 and 3, increases.

According to FIG. 6(b), the energy storage module #1 completes voltage balancing between the energy storage modules in Period 1, but performs voltage balancing between the internal cells in Periods 2 and 3, and voltage balancing between the cells is completed in Period 3.

According to of FIG. 6(c), in Period 1, the energy storage module #1 performs voltage balancing between the energy storage modules, so the number of unit cells performing voltage balancing is the total number of 18. In Period 2, the energy storage module #1 performs voltage balancing between the cells, and at this time, voltage balancing of 8 unit cells is performed. In Period 3, the number of unit cells performing voltage balancing gradually decreases.

As described above, according to the embodiment of the present disclosure, voltage balancing between energy storage modules may be achieved by direct communication between the energy storage modules connected in series without configuring a separate circuit for voltage balancing.

While this specification contains many features, such features should not be construed as limiting the scope of the present disclosure or the scope of the appended claims. Also, features described in individual embodiments herein may be combined and implemented in a single embodiment. Conversely, various features described in a single embodiment herein may be implemented individually or as appropriate combinations in various embodiments.

Although operations are illustrated in a particular order in the drawings, this should not be construed as such operations must be performed in the particular depicted order or in a series of sequential orders, or as all illustrated operations must be performed to achieve a desired result. Multitasking and parallel processing may be advantageous in certain environments. Furthermore, it should be understood that the distinction between various system components in the above embodiments does not require such distinction in all embodiments.

Various substitutions, modifications, and changes can be made to the present disclosure described above without departing from the technical idea of the present disclosure to those skilled in the art, and thus the present disclosure is not limited by the above embodiments and the accompanying drawings.

## Claims

1. An energy storage system comprising:
a plurality of energy storage modules connected in series, each energy storage module including a plurality of unit cells; and
a voltage balancing device installed in each energy storage module, the voltage balancing devices in the plurality of energy storage modules being configured to communicate with each other to perform voltage balancing among the plurality of energy storage modules.

2. The energy storage system according to claim 1,
wherein the voltage balancing device includes:
a voltage measurement unit configured to measure a voltage value of an energy storage module in which the voltage balancing device is installed;
a communication unit configured to communicate with other voltage balancing devices installed in other energy storage modules and receive voltage values of the other energy storage modules; and
a processing unit configured to perform voltage balancing of the energy storage module in which the voltage balancing device is installed based on the measured voltage value and the received voltage values of the other energy storage modules.

3. The energy storage system according to claim 2,
wherein the communication unit is configured to transmit and receive voltage values to/from the other voltage balancing devices through a CAN (Controller Area Network) communication message, and
wherein in an ID field of the CAN communication message, the serially connected energy storage modules have the same node ID, and each energy storage module has a different module ID.

4. The energy storage system according to claim 2,
wherein the processing unit performs voltage balancing of the energy storage module in which the voltage balancing device is installed, when the measured voltage value is greater than an average voltage value of the other energy storage modules by a predetermined value or more.

5. The energy storage system according to claim 2,
wherein the processing unit performs voltage balancing of the energy storage module in which the voltage balancing device is installed, when a difference between a largest voltage value and a smallest voltage value among the voltage values of the other energy storage modules is greater than a predetermined threshold value and the measured voltage value is greater than an average of the largest voltage value and the smallest voltage value.

6. The energy storage system according to claim 2,
wherein the processing unit performs voltage balancing of the energy storage module in which the voltage balancing device is installed, when the measured voltage value is higher than or equal to an alarm reference value.

7. The energy storage system according to claim 2,
wherein the processing unit performs voltage balancing between unit cells within the energy storage module, after voltage balancing of the energy storage module in which the voltage balancing device is installed is completed.

8. The energy storage system according to claim 7,
wherein the voltage measurement unit measures voltage values of the unit cells, and
wherein the processing unit performs voltage balancing of a specific unit cell, when the voltage value of the specific unit cell is greater than an average voltage value of the other unit cells by a predetermined value or more.

9. The energy storage system according to claim 7,
wherein the voltage measurement unit measures voltage values of the unit cells, and
wherein the processing unit performs voltage balancing of a specific unit cell, when a difference between a largest voltage value and a smallest voltage value among the voltage values of the unit cells other than the specific unit cell is greater than a predetermined threshold value and the voltage value of the specific unit cell is greater than an average of the largest voltage value and the smallest voltage value.

10. The energy storage system according to claim 7,
wherein the voltage measurement unit measures voltage values of the unit cells, and
wherein the processing unit performs voltage balancing of a specific unit cell, when the voltage value of the specific unit cell is greater than or equal to an alarm reference value.

11. A voltage balancing method of each voltage balancing device installed in each energy storage module in an energy storage system that includes a plurality of energy storage modules connected in series, each energy storage module including a plurality of unit cells, the voltage balancing method comprising:
performing voltage balancing among the plurality of energy storage modules by communicating with voltage balancing devices installed in other energy storage modules.

12. The voltage balancing method according to claim 11,
wherein the step of performing includes:
measuring a voltage value of an energy storage module in which the voltage balancing device is installed;
communicating with the other voltage balancing devices installed in the other energy storage modules to receive voltage values of the other energy storage modules; and
performing voltage balancing of the energy storage module in which the voltage balancing device is installed based on the measured voltage value and the received voltage values of the other energy storage modules.

13. The voltage balancing method according to claim 12,
wherein the step of receiving includes:
receiving voltage values from the other voltage balancing devices through a CAN (Controller Area Network) communication message,
wherein in an ID field of the CAN communication message, the serially connected energy storage modules have the same node ID, and each energy storage module has a different module ID.

14. The voltage balancing method according to claim 12,
wherein the step of performing voltage balancing of the energy storage module in which the voltage balancing device is installed includes:
performing voltage balancing of the energy storage module in which the corresponding voltage balancing device is installed, when the measured voltage value is greater than an average voltage value of the other energy storage modules by a predetermined value or more.

15. The voltage balancing method according to claim 12,
wherein the step of performing voltage balancing of the energy storage module in which the voltage balancing device is installed includes:
performing voltage balancing of the energy storage module in which the voltage balancing device is installed, when a difference between a largest voltage value and a smallest voltage value among the voltage values of the other energy storage modules is greater than a predetermined threshold value and the measured voltage value is greater than an average of the largest voltage value and the smallest voltage value.

16. The voltage balancing method according to claim 12, further comprising:
performing voltage balancing of the energy storage module in which the voltage balancing device is installed, when the measured voltage value is higher than or equal to an alarm reference value.

17. The voltage balancing method according to claim 12, further comprising:
performing voltage balancing between unit cells within the energy storage module, after voltage balancing of the energy storage module in which the voltage balancing device is installed is completed.

18. The voltage balancing method according to claim 17,
wherein the step of performing voltage balancing between unit cells includes:
measuring voltage values of the unit cells, and
performing voltage balancing of a specific unit cell, when the voltage value of the specific unit cell is greater than an average voltage value of the other unit cells by a predetermined value or more.

19. The voltage balancing method according to claim 17,
wherein the step of performing voltage balancing between unit cells includes:
measuring voltage values of the unit cells, and
performing voltage balancing of a specific unit cell, when a difference between a largest voltage value and a smallest voltage value among the voltage values of the unit cells other than the specific unit cell is greater than a predetermined threshold value and the voltage value of the specific unit cell is greater than an average of the largest voltage value and the smallest voltage value.

20. The voltage balancing method according to claim 17,
wherein the step of performing voltage balancing between unit cells includes:
measuring voltage values of the unit cells, and
performing voltage balancing of a specific unit cell, when the voltage value of the specific unit cell is greater than or equal to an alarm reference value.
